# EUROPÄISCHE PATENTANMELDUNG

(11) **EP 0 629 048 A2**
(43) Veröffentlichungstag der Anmeldung: **14.12.1994**
(21) Anmeldenummer: 94107905.5
(22) Anmeldetag: 21.05.1994
(51) Int. Cl.: H03M 1/18

(54) **Anordnung zur Analog/Digital-Wandlung von Signalen mit unterschiedlichem Signalpegel**

(30) Priorität: 11.06.1993 DE 4319376
(71) Anmelder: GRUNDIG E.M.V. Elektro-Mechanische Versuchsanstalt Max Grundig GmbH & Co. KG, D-90762 Fürth (DE)
(72) Erfinder: Lehmann, Reinhard, GRUNDIG E.M.V., D-90748 Fürth (DE); Siegert, Claus, GRUNDIG E.M.V., D-90748 Fürth (DE)

(57) **Zusammenfassung**

Die Erfindung betrifft eine Anordnung zur Analog/Digital-Wandlung von analogen Eingangssignalen mit unterschiedlichen Signalpegeln, bestehend aus einem Analog/Digitalwandler und einem Analogverstärker, dessen Verstärkungsfaktor veränderbar ist.

Bei der Analog/Digital-Wandlung von Signalen mit unterschiedlichen Pegeln wird die beste Auflösung für diese Signale erreicht, wenn eine Anpassung der Signalpegel an die Bereichsgrenzen des Analog/Digital-Wandlers oder umgekehrt durchgeführt wird.

Aufgabe der Erfindung ist es, eine Anordnung zur Analog/Digital-Wandlung von analogen Eingangssignalen anzugeben, die einen einfachen Aufbau aufweist und die eine zuverlässige Anpassung der Eingangssignalpegel an die die Bereichsgrenzen des Analog/Digital-Wandlers gewährleistet.

Dies wird mit einer Schaltungseinheit, die aus der Häufigkeit des Auftretens des Maximalwertes oder eines vorgebbaren Schwellwertes am Ausgang des Analog/Digital-Wandlers eine Stellgröße erzeugt, die den Verstärkungsfaktor des Analogverstärkers regelt, erreicht.

## Beschreibung

Die Erfindung betrifft eine Anordnung zur Analog/Digital-Wandlung nach dem Oberbegriff des Anspruches 1.

Bei der Analog/Digital-Wandlung von Signalen mit unterschiedlichen Pegeln wird die beste Auflösung für diese Signale erreicht, wenn eine Anpassung der Signalpegel an die Bereichsgrenzen des Analog/Digital-Wandlers oder umgekehrt durchgeführt wird.

Eine derartige Anpassung ist aus der europäischen Patentanmeldung EP-A-0 284 957 bekannt. Dort werden die Aussteuergrenzen des Analog/Digital-Wandlers solange verschoben, bis das Analogsignal die Aussteuergrenzen gerade nicht mehr überschreitet. Bei kleinen Signalpegeln werden die Aussteuergrenzen zunehmend eingeschränkt, bis eine erste Bereichsüberschreitung auftritt. Anschließend wird diese Einschränkung um einige Stufen wieder rückgängig gemacht, um sicherzugehen, daß das Eingangssignal diese Grenzen nicht überschreitet. Bei großen Signalpegeln werden die Aussteuergrenzen so lange erweitert, bis keine Bereichsüberschreitungen mehr auftreten. Die Einschränkung bzw. Erweiterung der Bereichsgrenzen wird erreicht, indem Bereichsüberschreitungen detektiert werden. Über eine geeignete Schaltungsanordnung wird dann mittels gesteuerter Stromquellen und Spannungsteilern die Referenzspannung des Analog/Digital-Wandlers verändert.

Aus der europäischen Patentanmeldung EP-A-0 271 936 ist es bekannt, nach der Analog/Digital-Wandlung das Digitalsignal auszuwerten, um eine Anpassung des Einganssignalpegels an die Bereichsgrenzen des Analog/Digital-Wandlers zu erreichen. Gemäß dieser Patentanmeldung wird das gewonnene Digitalsignal zu definierten Zeiten, an denen die Pegel des Analogsignales Scheitelwerte erreichen (Schwarzwert und Weißwert eines Fernsehsignales), ausgewertet. In Abhängigkeit dieser Auswertung wird der Verstärkungsfaktor eines gesteuerten Verstärkers, an dem das Eingangssignal anliegt, geregelt. Diese Analog/Digital-Wandleranordnung hat den Nachteil, daß sie nur bei Einganssignalen anwendbar ist, die zu definierten Zeiten ihre Scheitelwerte annehmen.

Allgemein einsetzbar ist eine Analog/Digital-Wandleranordnung, wie sie aus der europäischen Offenlegungsschrift EP-A-0 346 605 bekannt ist. Dort wird das Einganssignal gleichzeitig auf mehrere Verstärkungsschaltungen, die verschiedene Verstärkungsfaktoren aufweisen, gegeben. Jedem Verstärker ist ein Analog/Digital-Wandler zugeordnet, der jeweils ein Überlaufsignal erzeugt, wenn die Bereichsgrenzen überschritten werden. Die Überlaufsignale werden an eine logische Schaltung gegeben. Die Ausgangssignale der Analog/Digital-Wandler werden an einen Schalter geführt, der durch die logische Schaltung gesteuert wird und jeweils das Digitalsignal weiterschaltet, das gerade noch keinen Überlauf im Analog/Digital-Wandler aufweist. Anstelle der Analogverstärker in den verschiedenen Zweigen können Amplitudenbegrenzerschaltungen vorgesehen werden, die ebenfalls ein Überlaufsignal erzeugen. In diesem Fall wird bereits das Analogsignal an einen Schalter geführt und es wird entsprechend das Analogsignal weitergeschaltet, das gerade noch keinen Überlauf aufweist. Das weitergeschaltete Analogsignal wird einem Analog/Digital-Wandler zugeführt. Dadurch ist nicht mehr für jeden Zweig ein Analog/Digitalwandler nötig, dafür muß aber jeder Zweig einen Amplitudenbegrenzer enthalten, so daß der Aufbau der Schaltungsanordnung insgesamt nicht wesentlich vereinfacht wird.

Aus der deutschen Patentschrift DE-PS 38 16 903 ist ein Verfahren zur Analog/Digital-Wandlung von elektrischen Signalen bekannt, bei dem dem Analog/Digital-Wandler ein Analogverstärker vorgeschaltet ist, der zwei umschaltbare Verstärkungsfaktoren aufweist. Dem Analog/Digital-Wandler ist ausgangsseitig eine Vergleichsschaltung nachgeschaltet, die das digital gewandelte Signal mit einem Schwellwert vergleicht und ein Signal erzeugt, das angibt, ob der Schwellwert über- oder unterschritten wurde. In Abhängigkeit dieses Signales wird der eingangsseitige Analogverstärker auf einen der beiden Verstärkungsfaktoren umgeschaltet.

Aufgabe der Erfindung ist es, eine Anordnung zur Analog/Digital-Wandlung von analogen Eingangssignalen anzugeben, die einen einfachen Aufbau aufweist und die eine zuverlässige Anpassung der Eingangssignalpegel an die Bereichsgrenzen des Analog/Digital-Wandlers gewährleistet.

Diese Aufgabe wird bei einer Anordnung nach dem Oberbegriff des Anspruches 1 durch die Merkmale des kennzeichnenden Teils des Anspruches 1 gelöst. Gemäß der Erfindung wird eine logische Schaltungseinheit vorgesehen, die mit dem Ausgang des Analog/Digital-Wandlers verbunden ist und feststellt, ob der maximale Digitalwert oder ein vorgebbarer Schwellwert im digital gewandelten Signal vorliegt und die ein Signal ausgibt, das angibt, ob der Maximalwert oder der Schwellwert erreicht bzw. überschritten wurde. Es ist weiterhin eine Schaltungseinheit vorgesehen, der dieses Signal zugeführt wird und die aus der Häufigkeit des Auftretens dieses Signales eine Stellgröße erzeugt. Diese Stellgröße wird dem in seinem Verstärkungsfaktor veränderbaren Analogverstärker zugeführt.

Mit dieser Anordnung wird auf einfache Weise der Verstärkungsfaktor des Analogverstärkers so geregelt, daß das dem Analog/Digital-Wandler zugeführte Eingangssignal an die Bereichsgrenzen des Wandlers angepaßt ist.

Bei häufigem Auftreten des in der logischen Schaltungseinheit erzeugten Signales, d.h. bei häufigem Auftreten des Maximalwertes oder des vorgebbaren Schwellwertes am Ausgang des Analog/Digital-Wandlers wird der Verstärkungsfaktor verringert, während der Verstärkungsfaktor erhöht wird, wenn dieses Signal selten oder gar nicht auftritt.

Die Schaltungseinheit zur Erzeugung der Stellgröße besteht in vorteilhafter Weise aus einem zweiten Analogverstärker, dem ein Integrierglied nachgeschaltet ist.
Auf diese Weise wird ein analoges Stellsignal erzeugt, dessen Amplitude zunimmt, wenn der Maximalwert bzw. der Schwellwert am Ausgang des Analog/Digital-Wandlers häufig auftritt und dessen Amplitude abnimmt, wenn dieser Maximal- oder Schwellwert nicht oder nur selten auftritt.

Um Veränderungen des Eingangssignales, die durch die variable Verstärkung verursacht werden, auszugleichen, wird das die Verstärkung regelnde Stellsignal einer weiteren Schaltungseinheit zugeführt, die in Abhängigkeit von der Stellgröße, die den Verstärkungsfaktor des Analogverstärkers regelt, eine inverse Funktion zum veränderten Verstärkungsfaktor des Eingangsanalogverstärkers ausführt.

Diese Schaltungseinheit besteht in vorteilhafter Weise aus einem zweiten Analog/Digital-Wandler und einem digitalen Multiplizierer. Der digitale Multiplizierer multipliziert das vom ersten Analog/Digital-Wandler erhaltene Digitalsignal mit einem Digitalwert, der in Abhängigkeit des vom zweiten Analog/Digital-Wandler erhaltenen Signales bestimmt ist. Dieser Wert ist so ausgelegt, daß die durch die Verstärkung am Eingang des ersten Analog/Digital-Wandlers erfolgte Veränderung des Einganssignales rückgängig gemacht wird.

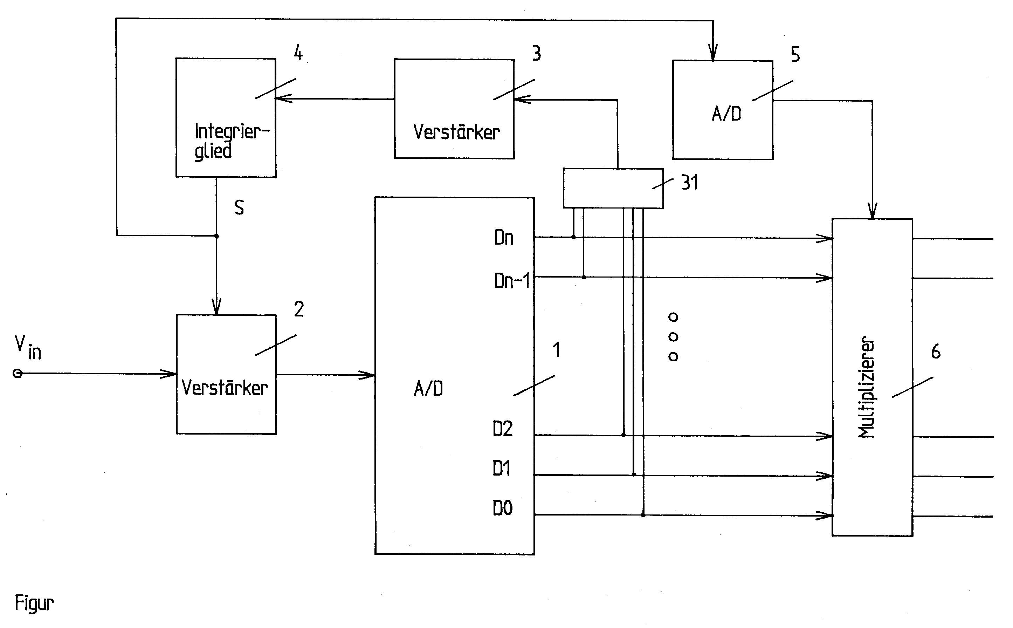

Im folgenden wird die Erfindung an Hand der Figur erläutert.
Diese Figur zeigt ein Blockschaltbild der erfindungsgemäßen Anordnung, bestehend aus einem ersten Analog/Digital-Wandler 1, einem ersten Verstärker 2 mit veränderbarem Verstärkungsfaktor, einer Logikeinheit 31, einem zweiten Verstärker 3 und einem Integrierglied 4. Weiterhin enthält die Anordnung einen zweiten Analog/Digital-Wandler 5 und einen digitalen Multiplizierer 6.

Das anloge Eingangssignal Vᵢₙ wird dem regelbaren Analogverstärker 2 zugeführt, dessen Ausgangssignal am Analog/Digital-Wandler 1 anliegt. Am Ausgang des Analog/Digital-Wandlers stehen n+1 Datenbits zur Verfügung, die dem Digitalwert des Analogsignales entsprechen. Diese n+1 Datenbits werden an die Logikeinheit 31 gegeben, die so ausgeführt ist, daß sie ein Signal erzeugt, das angibt, ob der der Maximalwert oder ein vorgebbarer Schwellwert des Digitalsignales am Ausgang des Analog/Digital-Wandlers vorliegt. Dieses Signal wird dem Analogverstärker 3, der einen vorgegebenen Verstärkungsfaktor aufweist, zugeführt. Das Signal am Ausgang dieses Verstärkers 3 wird an das Integrierglied 4 gegeben, an dessen Ausgang das Stellsignal S anliegt, das den Verstärkungsfaktor des Verstärkers 2 regelt. Das Stellsignal S wird weiterhin einem zweiten Analog/Digital-Wandler 5 zugeführt. Das digital gewandelte Signal wird als Multiplikationsfaktor dem Multiplizierer 5 zugeführt. Auf diese Weise werden Fehler durch den veränderten Verstärkungsfaktor am Analogverstärker 2 ausgeglichen.

Der Aufbau der Logikschaltung ist abhängig von dem im Analog/Digital-Wandler verwendeten Code. In dem Fall, daß durch das höchtstwertige Bit des erhaltenen Digitalsignales angegeben wird, daß der Maximalwert am Analog/Digital-Wandlerausgang anliegt, kann das höchstwertige Bit direkt an den Verstärker 3 angelegt werden.

Für den Fall, daß das digital gewandelte Stellsignal S nicht direkt zur inversen Funktion in Bezug auf den Verstärkungsfaktor am Eingansverstärker 2 führt, muß noch eine Gewichtung des Stellsignales S durchgeführt werden. Zu diesem Zweck kann beispielsweise vor dem Analog/Digital-Wandler 5 ein Analogverstärker mit vorgebbaren Verstärkungsfaktor oder nach dem Wandler 5 eine entsprechende Gewichtung mit digitalen Mitteln vorgesehen werden.

## Patentansprüche

1. Anordnung zur Analog/Digital-Wandlung von analogen Eingangssignalen mit unterschiedlichen Signalpegeln, bestehend aus einem Analog/Digital-Wandler (1) und einem diesen vorgeschalteten Analogverstärker (2), dessen Verstärkungsfaktor veränderbar ist, einer logischen Schaltungseinheit (31), die mit dem Ausgang des Analog/Digital-Wandlers verbunden ist und feststellt, ob der maximale Digitalwert oder ein vorgebbarer Schwellwert im digital gewandelten Signal vorliegt und die ein Signal ausgibt, das angibt, ob der Maximalwert oder der Schwellwert erreicht bzw. überschritten wurde oder nicht,
**gekennzeichnet durch**
eine Schaltungseinheit (3, 4), die aus der Häufigkeit des Auftretens des in der logischen Schaltungseinheit (31) erzeugten Signales eine Steilgröße (S) erzeugt, die den Verstärkungsfaktor des Analogverstärkers (2) regelt.

2. Anordnung nach Anspruch 1,
**dadurch gekennzeichnet**, daß
die Schaltungseinheit (3, 4) aus einem Analogverstärker (3) und einem Integrierglied (4) besteht.

3. Anordnung nach Anspruch 1 oder 2,
**dadurch gekennzeichnet**, daß
die Anordnung eine Schaltungseinheit (5, 6) enthält, die mit dem Ausgang des Analog/Digital-Wandlers (1) verbunden ist und die in Abhängigkeit von der Stellgröße (S), die den Verstärkungsfaktor des Analogverstärkers (2) regelt, eine inverse Funktion zum Verstärkungsfaktor des Analogverstärkers (2) ausführt.

4. Anordnung nach Anspruch 3,
**dadurch gekennzeichnet**, daß
die Schaltungseinheit (5, 6) aus einem Analog/Digital-Wandler (5), der durch das Steuersignal (S) angesteuert wird, und einem digitalen Multiplizierer (6), der mit dem Ausgang des Analog/Digital-Wandlers (1) verbunden ist, besteht.
